# EUROPEAN PATENT APPLICATION

(11) **EP 3 406 961 A1**
(43) Date of publication of application: **28.11.2018**
(21) Application number: 18159107.4
(22) Date of filing: 28.02.2018
(51) Int. Cl.: F21K 9/90, F21V 23/06, B32B 17/10, F21Y 115/10, F21Y 105/10, F21Y 109/00

(54) **A LIGHT-EMITTING DEVICE AND CORRESPONDING METHOD**

(30) Priority: 24.05.2017 IT 201700056220
(71) Applicant: OSRAM GmbH, 80807 München (DE); OSRAM S.P.A. - SOCIETA' RIUNITE OSRAM EDISON CLERICI, 20126 Milano (IT)
(72) Inventor: VENK, Mr. Sridharan, I-31100 Treviso (IT); GANZER, Mr. Enrico, I-31033 Castelfranco Veneto (Treviso) (IT); POGGI, Mr. Federico, I-30123 Venezia (IT)
(74) Representative: Bosotti, Luciano

(57) **Abstract**

A light-emitting device (100) includes:
- a flexible, light-permeable laminar substrate (102) of e.g. a plastic material such as polyethylene naphtalate - PEN,
- a distribution of laminar electrically-powered light radiation sources (100a) such as LEDs of the Chip Scale Package - CSP type on the laminar substrate (102),
- a layout of laminar e.g. ink-printed, electrically-conductive traces (102a) on the laminar substrate (102) serving the electrically-powered light radiation sources (100a).

## Description

### Technical field

The description relates to lighting devices.

One or more embodiments may include electrically-powered light radiation sources, such as solid-state light radiation sources, e.g. LED sources.

### Technological background

Illumination from glass has several potential applications, such as illumination from shower glazing, illumination from windows and door glazings, warning lights from vehicle windshields and so on.

Conventional designs for such applications involve assembling light radiation sources such as LEDs directly on glass substrates.

After LED assembly, lamination of two glass panels having the LED assembly sandwiched therebetween may be performed in different ways. A conventional technology involves using an adhesive layer such as polyvinyl butyral (PVB), the bonding process taking place under heat and pressure.

Assembling light radiation sources such as LEDs on glass may be expensive in view of the fairly sophisticated equipment and processes involved. Such an approach may also suffer from limitations e.g. in respect of the size of laminated glasses which can be produced.

Other forms of illumination from glass may involve placing light modules behind a glass panel. When resorting to this type of solution, the light module and the glass panel may represent separate elements intended to be eventually assembled at the application site.

Certain ones of these conventional techniques may permit to produce large-area light modules by connecting together various modules.

General information on these conventional technologies can be gathered at various website URLs.

For instance:
http://mediaglass.de/wp-content/uploads/Article-IGS.pdf
http://www.leuro.com/en/mediafacades/mediaglass
disclose a solution where LEDs are assembled directly on glass by putting a conductive resist on the glass, etching a pattern and then assembling LEDs.

Also:
http://www.yourglass.com/agc-glass-europe/be/en/led/glassiled/brand description.html
discloses arrangements where LEDs are assembled directly on the glass, while
http://www.lightntec.com/wp-content/uploads/2017/05/LightnTec-MSM-Mai17.pdf discloses arrangements with a flex foil not embedded in glass.

Corresponding commercial products are available under the designations Glassiled™ (Asahi Glass) and Mediaglass™ (Leurocom).

Even leaving other points aside, various types of solutions may not be suitable for glazing applications where a high degree of transparency is desirable. Embedded light modules for glazing applications with a high degree of transparency would thus represent a desirable solution.

### Object and summary

An object of one or more embodiments is to contribute in providing improvements over conventional arrangements as discussed in the foregoing.

According to one or more embodiments, that object can be achieved by means of a lighting device having the features set forth in the claims that follow.

One or more embodiments may relate to a corresponding method.

The claims are an integral part of the technical disclosure of embodiments as provided herein.

One or more embodiments may be suitable for various glazing applications and meet user needs not met by conventional solutions.

One or more embodiments make it possible to produce transparent flexible module designs e.g. in the form of continuous rolls.

One or more embodiments may be cut to length and shape according to application and/or design requirements, with sections of modules adapted to be produced to suit a variety of e.g. glass sizes.

In one or more embodiments such sections of modules can be laminated e.g. with glass, possibly before shipping for installation at an application site.

In one or more embodiments a relatively large area of a light module can be laminated between e.g. glass panes and then cut to specific application lengths and/or sizes.

One or more embodiments may be adapted for laminating between glass and/or plastics substrates such as glass and/or plastic panes.

One or more embodiments may be adapted for laminating between glass and/or plastic panes which may be fully light-permeable (transparent) or exhibit varying degrees of transparency.

### Brief description of the figures

One or more embodiments will now be described, by way of example only, with reference to the annexed figures, wherein:
- Figure 1 is a plan view of an embodiment of a light-emitting device,
- Figure 2 is an exemplary perspective view of an element adapted for inclusion in embodiments,

- Figure 3 is an exemplary perspective view of an element adapted for inclusion in embodiments,
- Figure 4 is exemplary of a lighting device including embodiments,
- Figure 5 is a schematic representation of possible steps in producing embodiments,
- Figures 6 and 7 are exemplary of possible details of embodiments,
- Figure 8 is exemplary of the possible use of such details in embodiments,
- Figure 9 is a plan view of embodiments,
- Figure 10 is a view of the portion of Figure 9 indicated by arrow X reproduced in an enlarged scale, and
- Figure 11 is an exploded perspective view of a lighting device according to embodiments.

It will be appreciated that, for the sake of clarity and ease of explanation, the various figures may not be drawn to a same scale.

Also, details and features illustrated, singly or in combination, in connection with embodiments as exemplified in any one of the annexed figures are not limited to possible use in such embodiments and can be applied, singly or in combination, in embodiments as exemplified in any other of the annexed figures.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

In the figures, reference 100 designates as a whole a light-emitting device.

In one or more embodiments as exemplified herein, the light-emitting device 100 includes a foil-like (e.g. plastic and/or light permeable) substrate 102 with electrically-powered light radiation sources 100a distributed thereon e.g. in a matrix arrangement.

In one or more embodiments, the light radiation sources 100a may include electrically-powered light radiation sources such as solid-state light radiation sources. LED sources (e.g. as discussed in the following) may be exemplary of such light radiation sources.

Referring to the device 100 as a "light-emitting device" takes into account the possibility of using such a device both as a stand-alone lighting device or as a component included in a more complex lighting device.

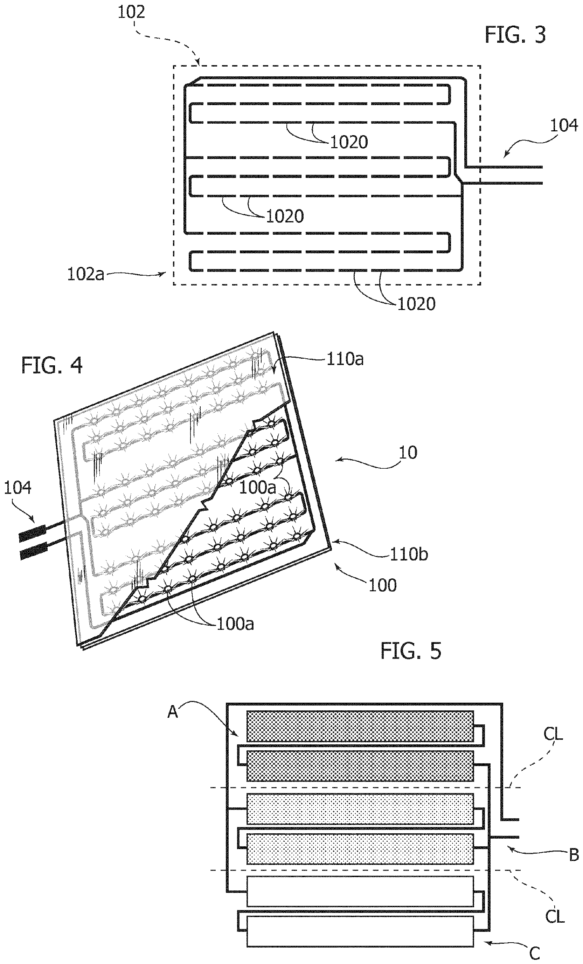

One or more embodiments may provide a light-permeable (transparent) lighting module 100, suitable for lamination between glass and/or plastic panes as exemplified in Figure 4 to be discussed in the following.

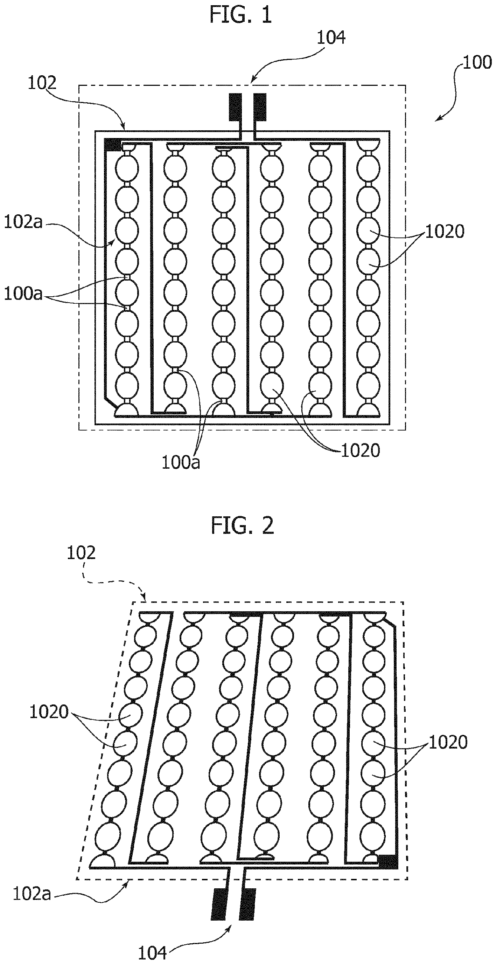

A light-emitting device as shown in Figure 1 may be included as a light-emitting layer 100 in an e.g. "stacked" structure of plural layers.

A lighting device including a stacked arrangement of layers wherein a light-emitting device 100 as exemplified herein may be included as a light-emitting layer is disclosed in Italian Patent Application No. 102017000056197 filed in the name of the same Applicants.

In one or more embodiments, the flexible substrate 102 may include electrically-conductive lines (e.g. printed traces) 102a carrying electrical signals (power supply and, possibly, control) for the light radiation sources 100a to be distributed on the substrate 102.

In one or more embodiments, the electrically-conductive lines 102a may come down to a set of terminals 104 including e.g. power supply terminals (and, possibly, control terminals) for the device 100.

In one or more embodiments, the substrate 102 may include plastic material such as PEN (polyethylene naphthalate) foil and/or LEDs 100a of the Chip Scale Package (CSP) type.

In one or more embodiments, the electrical traces 102a may be obtained by printing electrically-conductive ink (e.g. silver ink) onto the substrate 102. In one or more embodiments, traces 102a can be produced by resorting to other conventional techniques that are known per se.

While not a mandatory option, using a PEN substrate 102 facilitates achieving high clarity (e.g. in excess of 90%) of the substrate 102.

While, again, not a mandatory option, using CSP LEDs 100a makes it possible to take advantage of the 180° light directionality of CSP LEDs.

A useful feature of such type of LEDs is the reduced thickness e.g. below 1 mm), that is such LEDs being (very) thin, and thus laminar by themselves. This facilitates lamination between glass and/or plastic panes, thus making it possible to produce very thin lighting devices for use e.g. as glazing.

Using PEN for the substrate 102 and CSP LEDs for the light radiation sources 100a may facilitate obtaining layered structures (e.g. "sandwiches") of reduced thicknesses, with PEN exhibiting a good ability to withstand pressure and temperatures during lamination between e.g. glass and/or plastic panes.

The possibility also exists of using PEN in combination with standard adhesive materials (e.g. polyvinyl butyral - PVB) in lamination processes with the ability of PEN to retain a high degree of clarity after the lamination process.

In one or more embodiments, the light radiation sources 100a (e.g. CSP LEDs) can be assembled on the (e.g. PEN) substrate 102 by using a solder paste reflowing at low temperatures (e.g. by means of a low-temperature solder process), with the paste including e.g. metal spheres (balls) with an epoxy compound.

Such a low-temperature assembly method may facilitate achieving solder joints having a higher reliability than joints obtained through the use of e.g. a conventional isotropic conductive paste.

Other applications, wherein e.g. transparency requirements are more relaxed (e.g. lower than 90%) and/or where a larger resulting thickness is acceptable (e.g. greater than 1.0 mm) may resort to different options.

Also, while PEN offers higher process robustness than, say, polyethylene terephtalate (PET) and a lower cost than polyimide (PI), various glazing solutions may adopt such alternative materials.

Similarly, while (ink) printing may represent a viable option for producing the electrically-conductive formations or lines 102a well suited for use with PEN as the substrate material (primarily due to printing preserving the substrate transparency) other types of arrangements may be adopted for producing the electrically-conductive lines 102a. Rolled annealed or electro-deposited electrically-conductive materials may represent other options for use in embodiments.

Merely by way of example (and without wishing to limit the scope of embodiments) exemplary devices 100 as exemplified herein may include a matrix-like arrangements of LEDs 100a including e.g. a 6x8 matrix arrangement of LEDs of 1.20x0.8mm each. A possible thickness range for the substrate (PEN film) 102 may be between 75 and 125 micron - e.g. 120 micron (1 micron= 1.10⁻⁶m). Also, the LED chip may exhibit a thickness below 1mm, e.g. 900 micron (1 micron =1.10⁻⁶m).

In one or more embodiments, the pattern of electrically-conductive lines (traces) 102a may be intended to facilitate good thermal dissipation properties.

Figures 1 and 2 are exemplary of a possible layout of traces 102a including sections 1020 between the light sources 100a of an enlarged e.g. elliptical (or round) shape: such a shape may facilitate heat dissipation.

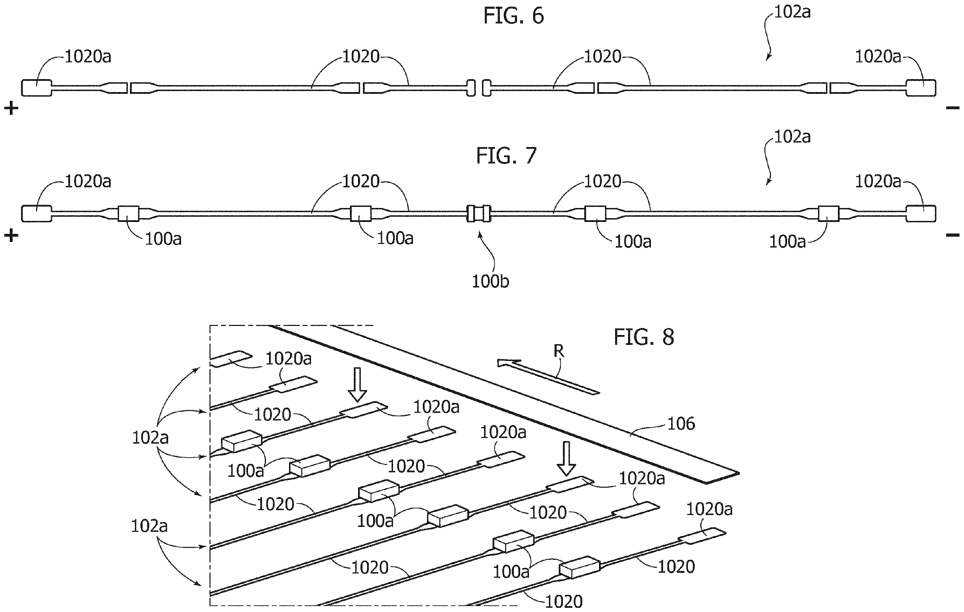

Embodiments as exemplified in Figures 3 and 4 as well as in Figures 6 to 11 are exemplary of embodiments wherein a leaner (i.e. wire-like) design may be adopted for subsequent sections 1020 of the electrically-conductive traces 102a in order to increase the amount of the area of the transparent substrate 102 not covered by the (e.g. printed) traces 102a.

As noted, electrically-conductive traces 102a may be provided by e.g. printing an electrically-conductive material (such as silver ink) thus facilitating achieving good thermal dissipation properties even in the presence of a thinner trace design.

In one or more embodiments, an increase in the transparent area may be obtained by using light-permeable (e.g. transparent) materials; a light-permeable ink (such as ITO - Indium Tin Oxide) may be exemplary of such material).

Figure 4 is exemplary of the possibility of producing a lighting device 10 by laminating a light-emitting device or layer 100 as discussed previously (e.g. with a trace pattern as exemplified in Figure 3) between two panes e.g. glass and/or plastic panes 110a, 110b.

A sandwiched arrangement as exemplified in Figure 4 may include a layout of electrically-conductive lines (traces) 102a as exemplified in Figures 1 and 2 in the place of the layout exemplified in Figure 3.

Again, it will be generally appreciated that features and characteristics exemplified in connection with a certain one of the annexed figures can be applied - singly or in combination - to embodiments exemplified in any other of the figures.

Figure 5 is generally exemplary of a possible approach which may be adopted in providing a flexible printed circuit (FPC) structure as exemplified herein.

For instance, Figure 5 may regarded as including three sections, designated A, B and C, respectively, and corresponding to three separate strings of light radiation sources 100a.

Each such string may include a set of sources (e.g. LEDs) connected in series.

Such an approach is compatible with conventional trace design principles as used e.g. in roll-to-roll (R2R) manufacturing of printed circuits, with the possibility of providing cutting lines CL to produce light modules of different lengths.

One or more embodiments may address issues related to shower/bathroom glazing applications and the associated safety requirements, compatible with a commercial design of a laminated film (light module) in glass.

Such an arrangement is desirable insofar as existing light modules directly printed on glass (that is, comprising an electrical circuit directly manufactured on the glass) and laminated to an additional glass pane are quite expensive and (in view of the sizes of the glass panels involved) almost invariably require large machine design and structures.

By way of contrast, a laminated film approach provides a roll of film, which can handled relatively easily in existing glass lamination process, with the possibility of being "customized" to the required sizes of glass panels.

Also, a low-voltage (e.g., 12V DC) solution is desirable in order to meet with safety requirements for shower/bathroom glazing application and similar applications (e.g. glazed glass for outdoor applications, bus terminals, train terminals, etc .... ).

One or more embodiments may provide, e.g., a LED layout complying with optical requirements and adopting a (big size) bus bar connection providing an adequate power supply from a low-voltage source even for lighting devices 10 of large dimensions.

One or more embodiments as exemplified, e.g. in Figures 6 to 11 may also provide homogeneous surface lighting (non-appreciable "hot spots"), flexibility also at the lighting portions while being compatible with dimming of LED sources.

In one or more embodiments a device 100 as exemplified herein (LED foils) can be made resizable (that is adapted to be cut from a roll at a desired length).

Also, the connectors (e.g., 104 in Figure 4) can be integrated at the end of the manufacturing process.

One or more embodiments may facilitate achieving good robustness of the LEDs (100a in the figures) after lamination (this applying, i.a., to the LED temperature within the glass and to phosphor robustness).

Figures 6 and 7 are exemplary of the electrically-conductive traces 102a which facilitate 12V DC operation. This in turn facilitates (electrical) safe shower/bathroom glazing application.

In one or more embodiments as exemplified in Figures 6 and 7, the electrically-conductive traces 102a can be realized as single electrical units (SEU's), of a length of e.g. 95,5 mm, including four LEDs 100a and an intermediate resistor 100b for current balancing.

These quantitative values (which facilitate fulfilling the requirements discussed previously) are of course purely exemplary and non-limitative of embodiments.

In one or more embodiments, the electrically-conductive traces 102a providing a conductive pattern/circuitry as exemplified herein can be produced by (e.g. screen-) printing electrically-conductive ink (e.g. silver-based ink) on a transparent/semitransparent polymeric substrate 102 (comprising e.g. a PEN, PET foil) or by etched copper technology on a transparent/semitransparent substrate 102 or a mix of the two technologies.

Particularly good results were obtained with samples manufactured with conductive ink printed on a PEN foil (flexible printed circuit - FPC).

In one or more embodiments as exemplified herein, the rectilinear SEUs (see again Figures 6 and 7) in the electrically-conductive traces 102a are arranged mutually parallel. This facilitates wrapping or winding the device 10 to a roll in a direction as exemplified by the arrow R in Figure 8.

As noted, high illuminance, low luminance, high uniformity (virtually no hot spots) and glare control are desirable features which are (quite) difficult to achieve in large size glazing application.

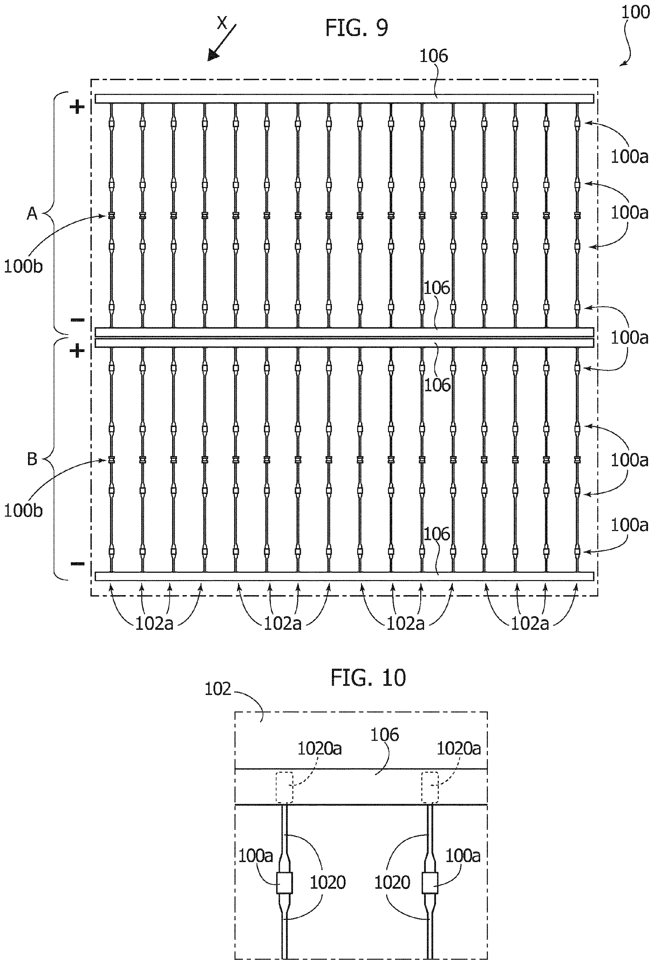

In one or more embodiments, these features were found to be achievable by using an array of SEUs as exemplified in Figures 9 and 10 (e.g. 4 LEDs per SEU) with the following (exemplary and non-limiting) characteristics:
- spacing (pitch) of adjacent SEUs (X-axis pitch in the plan view of Figure 10) = about 12,5 mm
- spacing of adjacent LEDs in each SEU (Y-axis pitch in the plan view of Figure 10) = about 25 mm.

The foregoing corresponds to a density of about 3200 LEDs/m² and a surface occupancy (circuitry area/apparent area) of about 23%.

Such an arrangement is compatible with standard LED packages.

The layout of the connection between the various SEUs as exemplified herein is otherwise rather free.

One or more embodiments may adopt a general layout as exemplified in Figure 9, that is with the SEUs having at their ends terminal contact lands 1020a to which electrically-conductive strip-like bus-bars 106 can be coupled. This arrangement has the advantage of being simple and symmetrical.

In one or more embodiments, the limited electrical conductivity of standard conductive inks can be taken into account by using (e.g. for long-haul applications) a hybrid configuration, wherein:
- the 12V DC SEU circuitry, carrying a limited current, can fully benefit from the use of conductive ink, with the ensuing advantages of high flexibility in design and short lead time;
- electrical coupling to a, e.g., 12V DC power supply (not visible in the Figures other than for the connectors 104) is made via the "secondary" bus-bars 106.

In one or more embodiments the bus-bars may comprise, e.g. 1 oz, metal Cu tape with an adhesive side adapted to be applied on the printed ink circuitry. Soldering of bus-bars may be a further option, while possibly suffering from thermal issues.

The high conductivity of standard copper, possibly in combination with the adoption of bus-bars with a large cross-section (e.g. continuous bus-bar - 1 oz), facilitates connecting several meters of flex for a continuous roll, e.g. for carrying high currents with a limited voltage drop.

A bus bar 106 comprising e copper tape with electrically-conductive adhesive on the bottom makes it possible to directly connect the 12V DC main line to the +/- pads 1020a.

An arrangement as exemplified in Figure 9 has the advantage of being simple and symmetric, including two sub-arrays A and B (rows) connectable in parallel (see e.g. the + and - signs in Figure 9) to a mains 12V DC power supply.

Other bus-bar connection layouts are of course possible, e.g., having less or more than four bus bars as exemplified herein (with possible limitations on the size of bus-bars 106 - that may become larger, thus decreasing the transparency of the light-emitting device - and on their electrical current load, that may increase).

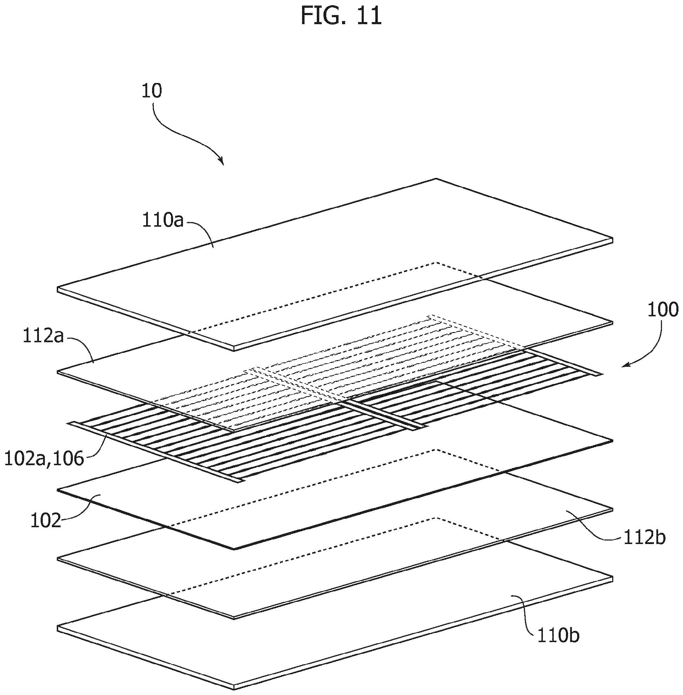

Figure 11 is exemplary of one or more embodiments where a light-emitting device 100 including the arrangement of parallel SEUs 102a and bus-bar 106 formed onto a substrate 102 is laminated between two panes e.g. glass and/or plastic panes 110a, 110b - as already discussed in connection with Figure 4 - with two light-permeable (adhesive or non-adhesive) lamination layers 112a (top) and 112b (bottom) set between the light-emitting device 100 and the panes 110a and 110b, respectively.

A light-emitting device (e.g. 100) according to one or more embodiments may include:
- a flexible, light-permeable laminar (e.g. foil-like) substrate (e.g. 102),
- a distribution of laminar electrically-powered light radiation sources (e.g. 100a) on the laminar substrate,
- a layout of laminar electrically-conductive formations (e.g. 102a) on the laminar substrate, the laminar electrically-conductive formations serving the electrically-powered light radiation sources

In one or more embodiments, the light-permeable substrate may include plastics material, optionally selected out of polyethylene naphtalate - PEN, polyethylene terephtalate - PET, and polyimide - PI.

In one or more embodiments, the light-permeable substrate may include polyethylene naphtalate - PEN.

In one or more embodiments, the electrically-powered light radiation sources may include solid-state light radiation sources such as LED sources.

In one or more embodiments, the electrically-powered light radiation sources may include LED sources of the Chip Scale Package - CSP type.

One or more embodiments may include low-temperature solder paste coupling the light radiation sources to the substrate.

In one or more embodiments, the low-temperature solder paste includes metal spheres with an epoxy compound.

In one or more embodiments, the electrically-conductive formations may include printed formations on the laminar substrate.

In one or more embodiments, the electrically-conductive formations may include expanded portions (see e.g. 1020 in Figures 1 and 2) between the light radiation sources.

In one or more embodiments, the electrically-conductive formations may include wire-like electrically-conductive formations (see e.g. 1020 in Figure 3).

In one or more embodiments, a light-emitting device according to one or more embodiments may be laminated with at least one light-permeable pane (e.g. 110a, 110b).

In one or more embodiments, a light-emitting device according to one or more embodiments may be sandwiched between two light-permeable panes (e.g. 110a, 110b).

In one or more embodiments the light-emitting device may be sandwiched between two light-permeable panes with light-permeable lamination layers (e.g. 112a, 112b) set between the light-emitting device and the light-permeable panes.

One or more embodiments may comprise:
- at least one array of linear (e.g. straight), electrically-conductive formations extending side-by side over the laminar substrate between opposed electrical contact lands (e.g. 1020a in Figures 8 and 11), and
- electrically-conductive bus-bars (e.g. 106) extending transverse the at least one array of linear, electrically-conductive formations in electrical contact with said electrical contact lands.

These bus-bars are couplable (see e.g. the terminals 104) to a supply source, such as e.g. a low-voltage (e.g. 12V DC) supply source.

In one or more embodiments:
- the at least one array may comprise electrically-conductive formations printed (e.g. with electrically conductive ink onto the (e.g. PEN) laminar substrate, and
- the electrically-conductive bus-bars may comprise electrically-conductive (e.g. metal, such as Cu) bodies (e.g., solid bodies such as strips) applied, optionally adhesively or non-adhesively, onto said electrical contact lands.

One or more embodiments (see e.g. Figure 9) may comprise a plurality (e.g. A, B) of said arrays of electrically-conductive formations jointly couplable to a supply source via respective electrically-conductive bus-bars.

In one or more embodiments, a method of providing light-emitting devices (100) may include:
- providing said flexible light-permeable laminar substrate (e.g. 102),
- distributing laminar electrically-powered light radiation sources (e.g. 100a) on the laminar substrate, and
- providing a layout of laminar electrically-conductive formations (e.g. 102a) serving the electrically-powered light radiation sources.

One or more embodiments may include coupling the light radiation sources to the substrate with a low-temperature solder process.

One or more embodiments may include coupling the light radiation sources to the substrate with a low-temperature solder paste including metal spheres with an epoxy compound.

Without prejudice to the underlying principles, the details and embodiments may vary, even significantly, with respect to what has been described by way of example only, without departing from the extent of protection. The extent of protection is defined by the annexed claims.

## Claims

1. A light-emitting device (100), including:
- a flexible, light-permeable laminar substrate (102),
- a distribution of laminar electrically-powered light radiation sources (100a) on the laminar substrate (102),
- a layout of laminar electrically-conductive formations (102a) on the laminar substrate (102), the laminar electrically-conductive formations (102a) serving the electrically-powered light radiation sources (100a).

2. The light-emitting device (100) of claim 1, wherein the light-permeable substrate (102) includes plastic material, preferably selected out of polyethylene naphtalate - PEN, polyethylene terephtalate - PET, and polyimide - PI.

3. The light-emitting device (100) of claim 2, wherein the light-permeable substrate (102) includes polyethylene naphtalate - PEN.

4. The light-emitting device (100) of any of claims 1 to 3, wherein the electrically-powered light radiation sources include solid-state light radiation sources such as LED sources (100a).

5. The light-emitting device (100) of claim 4, wherein the electrically-powered light radiation sources (100a) include LED sources of the Chip Scale Package - CSP type.

6. The light-emitting device (100) of any of the previous claims, including low-temperature solder paste coupling the light radiation sources (100a) to the substrate (102).

7. The light-emitting device (100) of claim 6, wherein the low-temperature solder paste includes metal spheres with an epoxy compound.

8. The light-emitting device (100) of any of the previous claims, wherein the electrically-conductive formations include printed formations (102a) on the laminar substrate (102).

9. The light-emitting device (100) of any of the previous claims, wherein the electrically-conductive formations (102a) include expanded portions (1020) between the light radiation sources (100a).

10. The light-emitting device (100) of any of the previous claims, wherein the electrically-conductive formations (102a) include wire-like electrically-conductive formations (1020).

11. The light-emitting device (100) of any of the previous claims, wherein the light-emitting device (100) is laminated with at least one light-permeable pane (110a, 110b).

12. The light-emitting device (100) of any of the previous claims, wherein the light-emitting device (100) is sandwiched between two light-permeable panes (110a, 110b).

13. The light-emitting device (100) of claim 12, wherein the light-emitting device (100) is sandwiched between two light-permeable panes (110a, 110b) with light-permeable lamination layers (112a, 112b) set between the light-emitting device (100) and the light-permeable panes (110a, 110b).

14. The light-emitting device (100) of claim 13, comprising:
- at least one array of linear, electrically-conductive formations (102a) extending side-by side over the laminar substrate (102) between opposed electrical contact lands (1020a), and
- electrically-conductive bus-bars (106) extending transverse the at least one array of linear, electrically-conductive formations (102a) in electrical contact with said electrical contact lands (1020a).

15. The light-emitting device (100) of claim 14, wherein:
- the at least one array comprises electrically-conductive formations (102a) printed onto the laminar substrate (102), and
- the electrically-conductive bus-bars (106) comprise electrically-conductive bodies applied onto said electrical contact lands (1020a).

16. The light-emitting device (100) of claim 14 or claim 15, comprising a plurality (A, B) of said arrays of electrically-conductive formations (102a) jointly couplable (104) to a supply source via respective electrically-conductive bus-bars (106).

17. A method of providing a light-emitting device (100) according to any of claims 1 to 16, the method including:
- providing said flexible light-permeable laminar substrate (102),
- distributing laminar electrically-powered light radiation sources (100a) on the laminar substrate (102), and
- providing a layout of laminar electrically-conductive formations (102a) serving the electrically-powered light radiation sources (100a).

18. The method of claim 17, including coupling the light radiation sources (100a) to the substrate (102) with a low-temperature solder process.

19. The method of claim 18, including coupling the light radiation sources (100a) to the substrate (102) with a low-temperature solder paste including metal spheres with an epoxy compound.
